# EUROPÄISCHE PATENTSCHRIFT

(11) **EP 1 045 462 B1**
(45) Veröffentlichungstag und Bekanntmachung des Hinweises auf die Patenterteilung: **03.10.2012**
(21) Anmeldenummer: 00103932.0
(22) Anmeldetag: 25.02.2000
(51) Int. Cl.: H01L 51/50, H01L 51/52

(54) **Lichtemittierende Diode mit organischen lichtemittierenden Stoffen zur Erzeugung von Licht mit Mischfarben**
Organic light emitting diode for producing mixed colour light
Diode organique émettrice de lumière pour produire de la lumière à couleurs mixtes

(30) Priorität: 13.04.1999 DE 19916745
(43) Veröffentlichungstag der Anmeldung: 18.10.2000
(73) Patentinhaber: Continental Automotive GmbH, 30165 Hannover (DE)
(72) Erfinder: Rupp, Christoph, 50825 Köln (DE); Reisinger, Achim, 65719 Hofheim (DE)

(56) Entgegenhaltungen:
- EP-A- 0 756 334
- EP-A1- 0 899 987
- WO-A-00/05703
- US-A- 5 283 132
- US-A- 5 796 509
- "ELECTRO-LUMINESCENT BACKLIGHT FOR COLOR DISPLAY" IBM TECHNICAL DISCLOSURE BULLETIN, IBM CORP. NEW YORK, US, Bd. 35, Nr. 2, 1. Juli 1992 (1992-07-01), Seiten 433-434, XP000313346 ISSN: 0018-8689
- PATENT ABSTRACTS OF JAPAN Bd. 1998, Nr. 12, 31. Oktober 1998 (1998-10-31) -& JP 10 189244 A (CASIO COMPUT CO LTD), 21. Juli 1998 (1998-07-21)
- GU G ET AL: "TRANSPARENT ORGANIC LIGHT EMITTING DEVICES" APPLIED PHYSICS LETTERS, AMERICAN INSTITUTE OF PHYSICS. NEW YORK, US, Bd. 68, Nr. 19, 6. Mai 1996 (1996-05-06), Seiten 2606-2608, XP000588302 ISSN: 0003-6951
- PATENT ABSTRACTS OF JAPAN Bd. 1997, Nr. 12, 25. Dezember 1997 (1997-12-25) -& JP 09 204982 A (NEC CORP), 5. August 1997 (1997-08-05)
- PATENT ABSTRACTS OF JAPAN Bd. 1998, Nr. 12, 31. Oktober 1998 (1998-10-31) -& JP 10 187058 A (SANYO ELECTRIC CO LTD), 14. Juli 1998 (1998-07-14)
- PATENT ABSTRACTS OF JAPAN Bd. 015, Nr. 442 (E-1131), 11. November 1991 (1991-11-11) & JP 03 187192 A (SEIKO EPSON CORP), 15. August 1991 (1991-08-15)

## Beschreibung

Die Erfindung betrifft lichtemittierende Dioden mit organischen lichtemittierenden Stoffen zur Erzeugung von Licht mit Mischfarben.

Für viele Anwendungen von, insbesondere flächenartig ausgebildeten, lichtemittierenden Dioden mit organischen lichtemittierenden Stoffen ist es wünschenswert, Licht mit Mischfarben, insbesondere Weiß erzeugen zu können. Im Gegensatz zu bestimmten anorganischen lichtemittierenden Schichten, die weißes Licht emittieren, das durch Benutzung von Filtern zur Erzeugung anderer Mischfarben verwendet werden kann, strahlt ein organischer lichtemittierender Stoff nur Licht einer Farbe ab.

Nach dem Stand der Technik sind dazu im wesentlichen zwei Verfahren zur Erzeugung von Licht mit Mischfarben, insbesondere Weiß, mit organischen lichtemittierenden Schichten bekannt.

Zum einen werden Schichten mit organischen Stoffen, die jeweils Licht verschiedener Farben emittieren, nebeneinander so angeordnet, daß sie bei geeigneter Strukturierung der Elektroden einzeln ansteuerbare Pixel bilden. Durch geeignete Ansteuerung kann dann Licht einer gewünschten Farbe abgestrahlt werden. Die entsprechenden Matrixanzeigen sind jedoch sehr aufwendig; insbesondere erfordert die Ansteuerung einzelner Pixel einen hohen Schaltungsaufwand.

Zum anderen ist, wie z.B. in der EP 0550 063 beschrieben, eine lichtemittierende Diode mit organischen lichtemittierenden Stoffen zur Erzeugung von Licht mit Mischfarben bekannt, bei der nur eine blaues Licht emittierende Schicht verwendet wird. Über jeweils zwei Teilpixeln befinden sich fluoreszierende Stoffe, die das blaue Licht in Licht längerer Wellenlänge, z.B. Grün und Rot, umsetzen. Dadurch wird eine erhöhte Lichtausbeute erreicht und eine unerwünschte Absorption von Licht weitgehend vermieden. Für Beleuchtungszwekke ist jedoch ein sehr hoher Aufwand erforderlich, da jedes Pixel einzeln anzusteuern ist.

Das Dokument "ELECTRO-LUMINESCENT BACKLIGHT FOR COLOR DISPLAY" IBM TECHNICAL DISCLOSURE BULLETIN, IBM CORP. NEW YORK, US, Bd. 35, Nr. 2, 1. Juli 1992, Seiten 433-434 beschreibt eine elektrolumineszente Vorrichtung, wobei die elektrolumineszente Schicht eine Streifenstruktur aufweist, und wobei Streifen eines Typs jeweils lichtemittierende Stoffe aufweisen, die Licht einer bestimmten Farbe emittieren, und wobei Streifen eines Typs gleich ansteuerbar sind.

Das Dokument JP10-189244, beschreibt eine elektrolumineszente Vorrichtung, wobei die elektrolumineszente Schicht eine Streifenstruktur aufweist und wobei die transparente Elektrode eine Kammzahn-Form hat, sodass Streifen eines Typs gleich ansteuerbar sind. Dokument JP09204982 beschreibt eine OLED-Vorrichtung, wobei die elektrolumineszente Schicht eine Streifenstruktur aufweist.

Aufgabe der Erfindung ist es daher, lichtemittierende Dioden mit organischen lichtemittierenden Stoffen zur Erzeugung von Licht mit Mischfarben bereitzustellen, die diese Nachteile nicht aufweisen.

Die Aufgabe wird gelöst durch eine lichtemittierende Diode mit organischen lichtemittierenden Stoffen zur Erzeugung von Licht mit Mischfarben mit den Merkmalen des Anspruchs 1.

Durch die Verwendung von alternierend angeordneten Streifen verschiedenen Typs, die entsprechend dem Typ angesteuert werden, können leicht Mischfarben erzeugt werden. Durch die erfindungsgemäße Ansteuerung der Streifen erhält man eine gleichmäßig ausgeleuchtete Fläche. In der einfachsten Form kann es bei geeigneter Auswahl der lichtemittierenden organischen Stoffe ausreichen, neben Masse nur ein weiteres Kabel zur Ansteuerung aller Streifen zu benutzen.

Die erfindungsgemäße lichtemittierende Diode kann zwischen den Elektrodenschichten noch weitere dem Fachmann bekannte Schichten enthalten, die die Funktion dieser Baugruppe verbessern.

Als organische lichtemittierende Stoffe können beliebige Stoffe Verwendung finden, wobei lichtemittierende Polymere bevorzugt sind.

Bevorzugte Weiterbildungen der Erfindung sind in den Unteransprüchen 2 bis 12 gekennzeichnet.

Vorzugsweise wird zur besseren Mischung des Lichts eine Streuschicht in Richtung der Beleuchtung aufgebracht. Im einfachsten Fall kann eine Streuscheibe als zweiter Träger ausgebildet sein.

Vorzugsweise ist die erste oder die zweite Elektrodenschicht entsprechend der Streifenstruktur zu Ansteuerung der Streifen jeweils eines Typs strukturiert, so daß durch Änderung der Ansteuerung die Farbe des abgestrahlten Mischlichts verändert werden kann. Gegenüber herkömmlichen Anzeigen mit zwei strukturierten Elektrodenschichten entfällt damit ein Strukturierungsschritt. Neben dem Masseanschluß sind dann weiterhin nur Anschlüsse für die einzelnen Streifentypen und nicht für die einzelnen Streifen notwendig, was den Aufwand zur Ansteuerung, Elektronik wie auch Anzahl der Anschlüsse, wesentlich reduziert.

Vorzugsweise werden mindestens drei Streifentypen verwendet, deren organische lichtemittierende Stoffe so gewählt sind, daß bei geeigneter Ansteuerung die Mischung des abgestrahlten Lichts der Streifen weißes Licht ergibt.

Zur Erhöhung der Lebensdauer der lichtemittierenden Schicht wird bevorzugt ein Dichtungselement vorgesehen, das rahmenartig entlang des Umfangs der Fläche der LED-Baugruppe zwischen den Trägern oder darauf angeordneten, festen Schichten angeordnet ist, so daß das Innere luft- und wasserdicht eingeschlossen ist.

Sind auch der zweite Träger und die zweite Elektrode transparent, ergibt sich eine beidseitig leuchtende lichtemittierende Diode.

Bei den transparenten Trägern kann es sich um Glas- oder geeignete Kunststoffplatten handeln.

Die Elektrodenschichten können die für lichtemittierende Dioden mit organischen lichtemittierenden Stoffen üblichen Materialien enthalten:

Die zweite Elektrodenschicht kann eine Metallschicht, z.B. Calcium oder Aluminium, enthalten.

Die transparenten Elektrodenschichten sind vorzugsweise Indium-Zinn-OxidSchichten (ITO-Schichten).

Bevorzugt ist zur Erhöhung der Lebensdauer zwischen der transparenten Elektrodenschicht und der Schicht mit organischen lichtemittierenden Stoffen eine polymere Schutzschicht angeordnet.

Soll Licht nur in einer Richtung abgestrahlt werden, kann die zweite Elektrodenschicht oder der zweite Träger der Diode in Richtung auf die lichtemittierende Schicht vorzugsweise reflektierend ausgebildet sein.

Ein weitere Aufgabe der Erfindung ist es, eine beleuchtete LCD-Anzeigevorrichtung bereitzustellen.

Die Aufgabe wird gelöst durch eine beleuchtete LCD-Anzeigevorrichtung mit den Merkmalen des Anspruchs 13.

Durch die Kombination der erfindungsgemäßen lichtemittierenden Diode mit einem an sich bekannten LCD-Anzeigemodul wird eine gegenüber einer LED-Matrixanzeige mit organischen lichtemittierenden Stoffen sehr einfache, preisgünstige, gleichmäßig ausgeleuchtete LCD-Anzeigevorrichtung bereitgestellt.

Bevorzugte Weiterbildungen der Anzeigevorrichtung sind in den Unteransprüchen 14 bis 17 gekennzeichnet.

In einer bevorzugten Ausführung entspricht die Breite der Streifen der Breite der Pixel des LCD- Anzeigemoduls; weiter sind die Streifen und die Pixel aufeinander ausgerichtet.

Bei konstantem Betrieb der Streifen kann dann mit einem einfachen LCD-, Anzeigemodul, das bis auf die Ansteuerung als Monochrom-Anzeigevorrichtung ausgebildet ist, eine selbstleuchtende Farbanzeigevorrichtung realisiert werden. Dazu werden nebeneinanderliegende Pixel über Streifen, die Licht verschiedener Farbe abstrahlen, zur Erzeugung eines Mischfarbenpixels angesteuert.

Bei dem LCD-Anzeigemodul kann es sich aber auch um ein zur Darstellung von mehrfarbigen Anzeigen bei einfarbiger oder weißer Beleuchtung ausgebildetes LCD-Anzeigemodul handeln.

Ausführungsbeispiele der Erfindung werden an Hand der Figuren beschrieben, in denen
Fig. 1 einen schematischen Schnitt durch eine lichtemittierende Diode mit organischen lichtemittierenden Stoffen zeigt,
Fig. 2 eine schematische Draufsicht auf die lichtemittierende Diode mit organischen lichtemittierenden Stoffen nach Fig. 1 zeigt,
Fig. 3 eine schematische Draufsicht auf eine lichtemittierende Diode mit organischen lichtemittierenden Stoffen nach der Erfindung zeigt,
Fig. 4 einen schematischen Schnitt durch eine beleuchtete LCD-Anzeigevorrichtung nach einer Ausführungsform der Erfindung zeigt, und
Fig. 5 eine schematische Draufsicht auf die lichtemittierende Diode mit organischen lichtemittierenden Stoffen nach Fig. 4 zeigt.

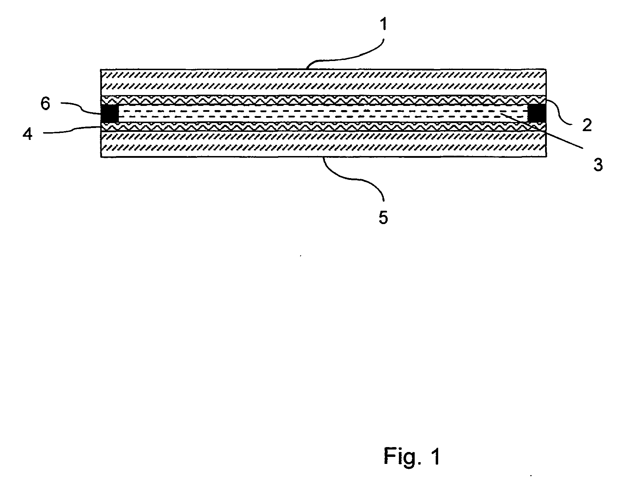

In Fig. 1 weist eine lichtemittierende Diode mit organischen lichtemittierenden Stoffen, eine als erster Träger und Streuscheibe dienende aufgerauhte Glasplatte 1, eine als erste transparente Elektrodenschicht dienende erste ITO-Schicht 2 (Indium-Zinn-Oxid-Schicht), eine lichtemittierende Polymerschicht 3, eine als zweite transparente Elektrodenschicht dienende Metall-Schicht 4 und eine als zweiter transparenter Träger dienende Glasplatte 5 auf. Die Schicht mit lichtemittierendem Polymer wird von einem als Dichtungselement dienenden, entlang des Umfangs der LED-Baugruppe verlaufenden Kleberahmen 6 luft- und wasserdicht eingeschlossen. Die Breite der Streifen ist so gering, daß die Streifenstruktur bei normaler Betrachtung mit dem menschlichen Auge nicht mehr auflösbar ist.

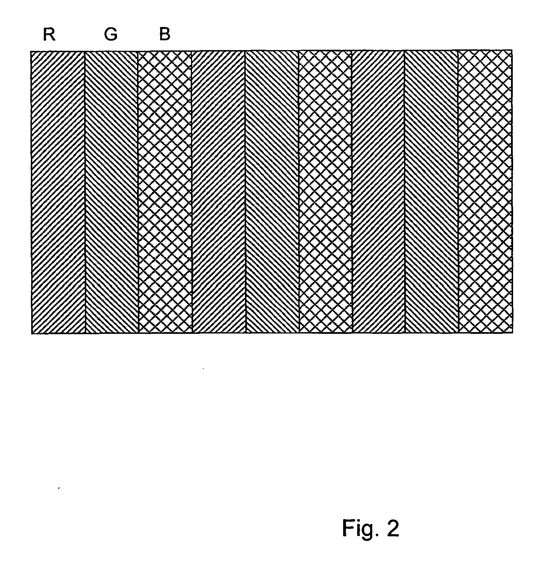

Wie in Fig. 2 gezeigt weist die eine lichtemittierende Polymerschicht eine Streifenstruktur mit alternierend aufeinanderfolgenden Streifen von drei Typen auf. Die Typen unterscheiden sich durch die lichtemittierenden Polymere, von denen je eines zur Abstrahlung von rotem (R), grünen (G) und blauem (B) Licht geeignet ist. Die Streifen eines Typs werden jeweils gleich angesteuert, so daß die Mischfarbe des abgestrahlten Lichts durch die Ansteuerung der Typen variiert werden kann.

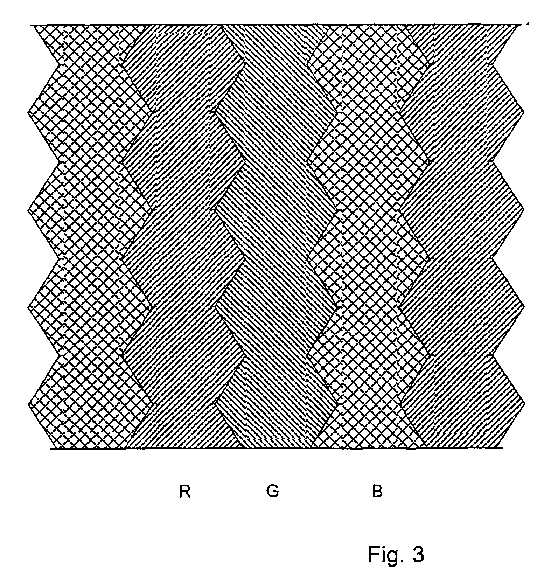

In der Erfindung hat eine lichtemittierende Diode mit organischen lichtemittierenden Stoffen im Schnitt den gleichen Aufbau wie in Fig. 1, jedoch sind, wie in Fig. 3 gezeigt, die Streifen zahnförmig ausgebildet und ineinander verzahnt, so daß sich für das Auge eine bessere Mischung ergibt.

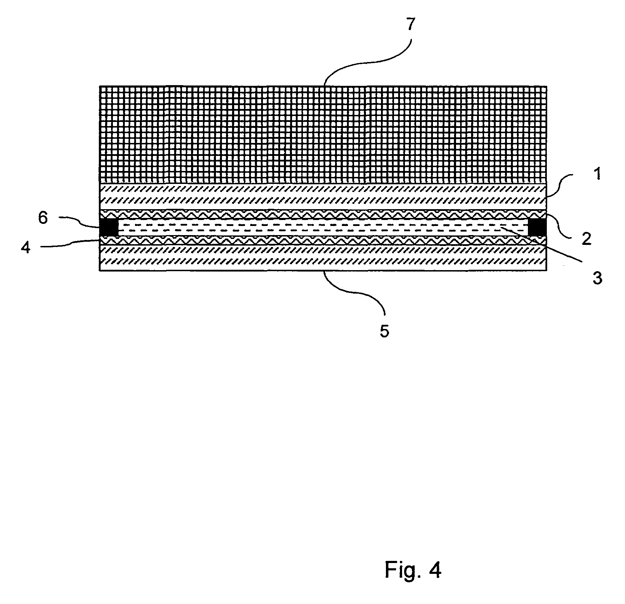

Eine beleuchtete LCD-Anzeigevorrichtung nach einer Ausführungsform der Erfindung ist im Schnitt in Fig. 4 gezeigt. Ein LCD-Modul 7 ist über einer lichtemittierenden Diode mit organischen lichtemittierenden Stoffen, die im wesentlichen den gleichen Aufbau wie die nach der ersten Ausführungsform der Erfindung hat, angeordnet. Die lichtemittierende Diode ist wie in Fig. 1 und Fig. 2 aufgebaut; es werden daher auch die gleichen Bezugszeichen verwendet. Es sind als Farben Rot (R), Grün (G) und Blau (B) vorgesehen, so daß eine Mischung des abgestrahlten Lichts bei geeigneter Ansteuerung weißes Licht ergibt. Die erste Elektrodenschicht 2 ist entsprechend der Streifenstruktur so strukturiert, daß Streifen jeweils eines Typs unabhängig von denen eines anderen Typs ansteuerbar sind. Im Betrieb leuchten alle Streifen gleichzeitig, so daß weißes Licht entsteht. Prinzipiell können durch andere Ansteuerungen aber auch andere Farbmischungen abgestrahlt werden.

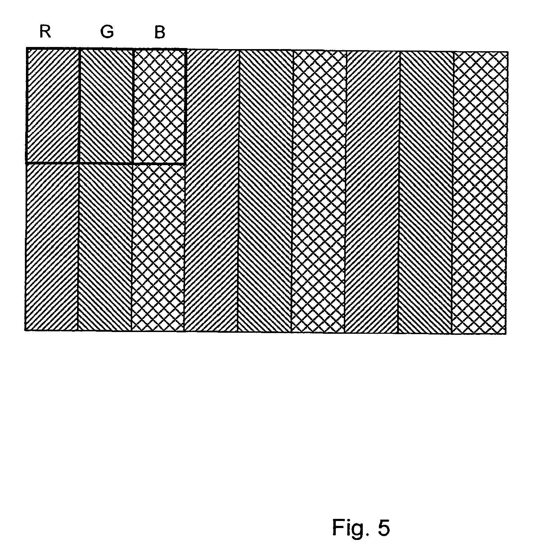

Das LCD-Modul 7 hat den Aufbau einer LCD-Anzeigevorrichtung für Monochrombetrieb; die Pixel dieses Moduls werden hier als Sub-Pixel bezeichnet. Ihre Breite entspricht gerade der Breite eines Streifens und sie sind direkt über den Streifen angeordnet. Wie in der Fig. 5 gezeigt, bilden drei über benachbarten Streifen angeordnete Sub-Pixel R, G, B ein Pixel des anzuzeigenden Bildes. Da die Sub-Pixel konstant beleuchtet werden, kann durch Einstellung ihres Durchlaßvermögens die Farbe eines Pixels durch Mischung der Lichtstärken der drei Sub-Pixel mit roter, grüner und blauer Farbe eingestellt werden. So erhält man einfach eine beleuchtete Farb-LCD-Anzeigevorrichtung.

## Patentansprüche

1. Lichtemittierende Diode mit organischen lichtemittierenden Stoffen zur Erzeugung von Licht mit Mischfarben mit einem ersten transparenten Träger (1), einer ersten transparenten Elektrodenschicht (2), einer Schicht (3) enthaltend organische lichtemittierende Stoffe, einer zweiten Elektrodenschicht (4) und einem zweiten Träger (5) sowie gegebenenfalls weiteren zwischen der ersten und zweiten Elektrodenschicht enthaltenden Schichten, wobei die Schicht (3) mit organischen lichtemittierenden Stoffen eine Streifenstruktur aufweist, bei der mindestens zwei Typen von Streifen alternierend angeordnet sind, und wobei Streifen eines Typs jeweils organische lichtemittierende Stoffe aufweisen, die Licht einer bestimmten Farbe emittieren, und wobei Streifen eines Typs gleich ansteuerbar sind, sodass nur Anschlüsse für die einzelnen Streifentypen und nicht für die einzelen Streifen notwendig sind, **dadurch gekennzeichnet, daß** die Streifen auf mindestens einer Seite eine Zahnung aufweisen und ineinander verzahnt sind.

2. Lichtemittierende Diode mit organischen lichtemittierenden Stoffen nach Anspruch 1, **dadurch gekennzeichnet, daß** die erste oder die zweite Elektrodenschicht (2,4) entsprechend der Streifenstruktur zu Ansteuerung der Streifen jeweils eines Typs strukturiert ist.

3. Lichtemittierende Diode mit organischen lichtemittierenden Stoffen nach Anspruch 1 oder 2, **dadurch gekennzeichnet, daß** mindestens drei Streifentypen (R,G,B) verwendet sind, deren organische lichtemittierende Stoffe so gewählt sind, daß bei geeigneter Ansteuerung die Mischung des abgestrahlten Lichts der Streifen weißes Licht ergibt.

4. Lichtemittierende Diode mit organischen lichtemittierenden Stoffen nach einem der vorhergehenden Ansprüche, **dadurch gekennzeichnet, daß** die transparente Elektrodenschicht (2) eine ITO-Schicht ist.

5. Lichtemittierende Diode mit organischen lichtemittierenden Stoffen nach einem der vorhergehenden Ansprüche, **dadurch gekennzeichnet, daß** zwischen der transparenten Elektrodenschicht (2) und der Schicht (3) mit organischen lichtemittierenden Stoffen eine polymere Schutzschicht angeordnet ist.

6. Lichtemittierende Diode mit organischen lichtemittierenden Stoffen nach einem der Ansprüche 2 bis 5, **dadurch gekennzeichnet, daß** ein Dichtungselement (6) rahmenartig entlang des Umfangs der Fläche der lichtemittierende Diode zwischen dem ersten transparenten Träger (1) und dem zweiten Träger (5) oder darauf angeordneten festen Schichten angeordnet ist, so daß das Innere luft- und wasserdicht eingeschlossen ist.

7. Lichtemittierende Diode mit organischen lichtemittierenden Stoffen nach einem der vorhergehenden Ansprüche, **dadurch gekennzeichnet, daß** der zweite Träger (5) transparent ist.

8. Lichtemittierende Diode mit organischen lichtemittierenden Stoffen nach einem der vorhergehenden Ansprüche, **dadurch gekennzeichnet, daß** die transparenten Träger (1) Glasplatten sind.

9. Lichtemittierende Diode mit organischen lichtemittierenden Stoffen nach einem der vorhergehenden Ansprüche, **dadurch gekennzeichnet, daß** die zweite Elektrodenschicht (4) transparent ist.

10. Lichtemittierende Diode mit organischen lichtemittierenden Stoffen nach einem der Ansprüche 1 bis 9, **dadurch gekennzeichnet, daß** die zweite Elektrodenschicht (4) eine Metallschicht ist.

11. Lichtemittierende Diode mit organischen lichtemittierenden Stoffen nach einem der vorhergehenden Ansprüche, **dadurch gekennzeichnet, daß** sie eine Streuschicht auf der ersten Elektrodenschicht (2) oder gegebenenfalls dem ersten Träger (1) aufweist.

12. Lichtemittierende Diode mit organischen lichtemittierenden Stoffen nach einem der Ansprüche 1 bis 10, **dadurch gekennzeichnet, daß** der erste transparente Träger (1) als Streuschicht ausgebildet ist.

13. Beleuchtete LCD-Anzeigevorrichtung enthaltend ein LCD-Anzeigemodul (7), **dadurch gekennzeichnet, daß** eine lichtemittierende Diode mit organischen lichtemittierenden Stoffen nach einem der vorhergehenden Ansprüche als Hinterleuchtungsvorrichtung parallel zur Fläche des LCD-Moduls (7) angeordnet ist, wobei die Streifen konstant Licht emittieren.

14. Beleuchtete LCD-Anzeigevorrichtung enthaltend eine LCD-Anzeigevorrichtung nach Anspruch 13, **dadurch gekennzeichnet, daß** die Breite der Streifen der Breite der Pixel des LCD- Anzeigemoduls entspricht und daß die Streifen und die Pixel aufeinander ausgerichtet sind.

15. Beleuchtete LCD-Anzeigevorrichtung nach Anspruch 13 oder 14, **dadurch gekennzeichnet, daß** das LCD-Anzeigemodul (7) bis auf die Ansteuerung als Monochrom-Anzeigevorrichtung ausgebildet ist.

16. Beleuchtete LCD-Anzeigevorrichtung nach Anspruch 15, **dadurch gekennzeichnet, daß** nebeneinanderliegende Pixel über verschiedenen Streifen zur Erzeugung eines Mischfarbenpixels angesteuert werden.

17. Beleuchtete LCD-Anzeigevorrichtung nach einem der Ansprüche 13 oder 14, **dadurch gekennzeichnet, daß** das LCD-Anzeigemodul (7) zur Darstellung von mehrfarbigen Anzeigen bei einfarbiger oder weißer Beleuchtung ausgebildet ist.

## Claims

1. Light-emitting diode with organic light emitting materials for producing light with mixed colors, having a first transparent substrate (1), a first transparent electrode layer (2), a layer (3) containing organic light emitting materials, a second electrode layer (4) and a second substrate (5) as well as, if appropriate, further layers contained between the first and second electrode layers, the layer (3) with organic light emitting materials having a strip structure in which at least two types of strips are arranged alternately, and strips of one type in each case having organic light emitting materials which emit light of a specific color, and it being possible for strips of one type to be driven identically, with the result that what are necessary are only terminals for the individual types of strip and not for the individual strips, **characterized in that** the strips have a toothed system on at least one side and are intermeshed by the teeth.

2. Light emitting diode with organic light emitting materials according to Claim 1, **characterized in that** the first or the second electrode layer (2, 4) is structured in accordance with the strip structure for driving the strips of in each case one type.

3. Light emitting diode with organic light emitting materials according to Claim 1 or 2, **characterized in that** use is made of at least three types (R, G, B) of strip whose organic light emitting materials are selected such that with suitable driving the mixing of the emitted light of the strips yields white light.

4. Light emitting diode with organic light emitting materials according to one of the preceding claims, **characterized in that** the transparent electrode layer (2) is an ITO layer.

5. Light emitting diode with organic light emitting materials according to one of the preceding claims, **characterized in that** a polymeric protective layer is arranged between the transparent electrode layer (2) and the layer (3) with organic light emitting materials.

6. Light emitting diode with organic light emitting materials according to one of Claims 2 to 5, **characterized in that** a sealing element (6) is arranged like a frame along the circumference of the surface of the light emitting diode between the first transparent substrate (1) and the second substrate (5) or solid layers arranged thereon, with the result that the interior is enclosed in an airtight and watertight fashion.

7. Light emitting diode with organic light emitting materials according to one of the preceding claims, **characterized in that** the second substrate (5) is transparent.

8. Light emitting diode with organic light emitting materials according to one of the preceding claims, **characterized in that** the transparent substrates (1) are glass plates.

9. Light emitting diode with organic light emitting materials according to one of the preceding claims, **characterized in that** the second electrode layer (4) is transparent.

10. Light emitting diode with organic light emitting materials according to one Claims 1 to 9, **characterized in that** the second electrode layer (4) is a metal layer.

11. Light emitting diode with organic light emitting materials according to one of the preceding claims, **characterized in that** it has a diffusing layer on the first electrode layer (2) or, if appropriate, the first substrate (1).

12. Light emitting diode with organic light emitting materials according to one of Claims 1 to 10, **characterized in that** the first transparent substrate (1) is designed as a diffusing layer.

13. Illuminated LCD display device containing an LCD display module (7), **characterized in that** a light emitting diode with organic light emitting materials according to one of the preceding claims is arranged as a backlighting device parallel to the surface of the LCD module (7), the strips emitting light constantly.

14. Illuminated LCD display device containing an LCD display device according to Claim 13, **characterized in that** the width of the strips corresponds to the width of the pixels of the LCD display module, and **characterized in that** the strips and the pixels are aligned with one another.

15. Illuminated LCD device according to Claim 13 or 14, **characterized in that** the LCD display module (7) is designed as a monochromatic display device except for the drive.

16. Illuminated LCD device according to Claim 15, **characterized in that** juxtaposed pixels are driven via different strips to produce a mixed color pixel.

17. Illuminated LCD device according to one of Claims 13 or 14, **characterized in that** the LCD display module (7) is designed for representing polychromatic displays in conjunction with monochromatic or white illumination.

## Revendications

1. Diode électroluminescente ayant des substances organiques électroluminescentes de production de lumière ayant des couleurs mélangées, comprenant un premier support (1) transparent, une première couche (2) transparente formant électrode, une couche (3) contenant des substances organiques électroluminescentes, une deuxième couche (4) formant électrode et un deuxième support (5) ainsi que le cas échéant d'autres couches contenues entre la première et la deuxième couches formant électrode, la couche (3) ayant des substances organiques électroluminescentes ayant une structure en bandes dans laquelle au moins deux types de bande sont disposés en alternance et dans laquelle les bandes d'un type ont respectivement des substances organiques électroluminescentes et émettent de la lumière d'une couleur déterminée et dans laquelle des bandes d'un type peuvent être commandées en même temps de manière à ne nécessiter des bornes que pour les types individuels de bandes et non pour les bandes individuelles, **caractérisée en ce que** les bandes ont une denture au moins d'un côté et sont engrenées les unes dans les autres.

2. Diode électroluminescente ayant des substances organiques électroluminescentes suivant la revendication 1, **caractérisée en ce que** la première ou la deuxième couche (2, 4) formant électrode est structurée conformément à la structure de bande pour la commande des bandes de respectivement un type.

3. Diode électroluminescente ayant des substances organiques électroluminescentes suivant la revendication 1 ou 2, **caractérisée en ce que** sont utilisés au moins trois types (R, G, B) de bande dont les substances organiques électroluminescente sont choisies de manière à donner, pour une excitation appropriée, le mélange de la lumière émise de la bande de lumière blanche.

4. Diode électroluminescente ayant des substances organiques électroluminescentes suivant la revendication précédente, **caractérisée en ce que** la couche (2) transparente formant électrode est une couche ITO.

5. Diode électroluminescente ayant des substances organiques électroluminescentes suivant l'une des revendications précédentes, **caractérisée en ce qu'**une couche de protection en polymère est disposée entre la couche (2) transparente formant électrode et la couche (3) ayant des substances organiques électroluminescentes.

6. Diode électroluminescente ayant des substances organiques électroluminescentes suivant l'une des revendications 2 à 5, **caractérisée en ce qu'**un élément (6) d'étanchéité est disposé à la manière d'un cadre le long du pourtour de la surface de la diode électroluminescente entre le premier support (1) transparent et le deuxième support (5) ou des couches fixes qui y sont disposées de manière à ce que l'intérieur soit enfermé de manière étanche à l'air et à l'eau.

7. Diode électroluminescente ayant des substances organiques électroluminescentes suivant l'une des revendications précédentes, **caractérisée en ce que** le deuxième support (5) est transparent.

8. Diode électroluminescente ayant des substances organiques électroluminescentes suivant l'une des revendications précédentes, **caractérisée en ce que** les supports (1) transparents sont des plaques de verre.

9. Diode électroluminescente ayant des substances organiques électroluminescentes suivant l'une des revendications précédentes, **caractérisée en ce que** la deuxième couche (4) formant électrode est transparente.

10. Diode électroluminescente ayant des substances organiques électroluminescentes suivant l'une des revendications 1 à 9, **caractérisée en ce que** la deuxième couche (4) formant électrode est une couche métallique.

11. Diode électroluminescente ayant des substances organiques électroluminescentes suivant l'une des revendications précédentes, **caractérisée en ce qu'**elle comporte une couche de diffusion sur la première couche (2) formant électrode ou le cas échéant sur le premier support (1).

12. Diode électroluminescente ayant des substances organiques électroluminescentes suivant l'une des revendications 1 à 10, **caractérisée en ce que** le premier support (1) transparent est constitué sous la forme d'une couche de diffusion.

13. Dispositif d'affichage LCD éclairé, comprenant un module (7) d'affichage LCD, **caractérisé en ce qu'**une diode électroluminescente ayant des substances organiques électroluminescentes suivant l'une des revendications précédentes est disposée en tant que dispositif d'éclairage arrière parallèlement à la surface du module (7) LCD, les bandes émettant constamment de la lumière.

14. Dispositif d'affichage LCD éclairé, comprenant un dispositif d'affichage LCD suivant la revendication 13, **caractérisé en ce que** la largeur des bandes correspond à la largeur des pixels du module d'affichage LCD et **en ce que** les bandes et les pixels sont alignés les uns avec les autres.

15. Dispositif d'affichage LCD éclairé, suivant la revendication 13 ou 14, **caractérisé en ce que** le module (7) d'affichage LCD est constitué à l'exception de la commande en tant que dispositif d'affichage monochrome.

16. Dispositif d'affichage LCD éclairé, suivant la revendication 15, **caractérisé en ce que** les pixels disposés les uns à côté des autres sont excités par des bandes différentes pour la production d'un pixel de couleurs mélangées.

17. Dispositif d'affichage LCD éclairé, suivant l'une des revendications 13 ou 14, **caractérisé en ce que** le module (7) d'affichage LCD est constitué pour la représentation d'affichage en plusieurs couleurs pour un éclairage à une seule couleur ou blanc.
